# EUROPÄISCHE PATENTANMELDUNG

(11) **EP 1 432 279 A2**
(43) Veröffentlichungstag der Anmeldung: **23.06.2004**
(21) Anmeldenummer: 03104228.6
(22) Anmeldetag: 17.11.2003
(51) Int. Cl.: H04R 1/06, H04M 1/03

(54) **Mittel zum Kontaktieren von in Kommunikationsendgeräten platzierten elektrotechnischen Komponenten und Kommunikationsendgerät mit solchen Mitteln**

(30) Priorität: 19.12.2002 DE 10259837
(71) Anmelder: SIEMENS AKTIENGESELLSCHAFT, 80333 München (DE)
(72) Erfinder: Veurman, Johannes, 7103 BN Winterswijk (NL); Herrmann, Stephan, 46244 Bottrop (DE)

(57) **Zusammenfassung**

Es werden Mittel (22) zum billigeren und einfacheren Kontaktieren von in Kommunikationsendgeräten platzierten elektrotechnischen Komponenten (z.B. 21) wie zum Beispiel ein Lautsprecher mit einer elektrotechnischen Funktionsbaugruppe (z.B. 2) wie zum Beispiel eine Leiterplatte vorgeschlagen. Ferner wird ein Kommunikationsendgerät vorgeschlagen, das billiger herstellbar ist. Die Mittel (22) sind aus einer Kombination von elektrischen Verbindungsteilen (23) und mechanischem Körperteil (24) gebildet, durch die ein auf Grund einer vorgegebenen Bauform der elektrotechnischen Komponente (z.B. 21) und eines vorgegebenen Einbauortes der elektrotechnischen Komponente (z.B. 21) innerhalb des Kommunikationsendgeräts zwischen der elektrotechnischen Funktionsbaugruppe (2) des Kommunikationsendgeräts und der elektrotechnischen Komponente (z.B. 21) vorhandener Freiraum (36) elektrisch und mechanisch überbrückt ist. Dabei können die Mittel (22) wie ein elektronisches Bauteil montiert werden.

## Beschreibung

Die Erfindung betrifft Mittel zum Kontaktieren von in Kommunikationsendgeräten platzierten elektrotechnischen Komponenten gemäß dem Oberbegriff des Anspruchs 1. Die Erfindung betrifft weiter ein Kommunikationsendgerät gemäß dem Oberbegriff des Anspruchs 5.

Bedingt durch die zunehmende Miniaturisierung von mobilen und schnurlosen Telefonapparaten und der gleichzeitigen Zunahme von Leistungsmerkmalen, beispielsweise denen von Lautsprechern als eine elektrotechnische Komponente, wird auch der für die Bestückung der Bauelemente benötigte Freiraum auf der Leiterplatte als eine elektrotechnische Funktionsbaugruppe immer geringer. Gerade zum Beispiel der Lautsprecher nimmt durch seine Größe sehr viel Platz in Anspruch. Ein kleinerer Lautsprecher besitzt deutlich schlechtere Akustik-Merkmale, weswegen ein möglichst großer Lautsprecher als die optimale Lösung angesehen wird. Ein solcher Lautsprecher muss sich allerdings zum einen auf der Leiterplatte abstützen, zum anderen muss er aber auch mit dieser elektrisch kontaktieren.

Verschiedene Realisierungsmöglichkeiten für eine Kontaktierung beispielsweise zwischen dem Lautsprecher und der Leiterplatte sind bekannt. Allen gemeinsam ist der Umstand, dass die Mittel zum Kontaktieren leitende Verbindungsteile umfassen, mit deren Hilfe der Lautsprecher mit der Leiterplatte kontaktiert wird.

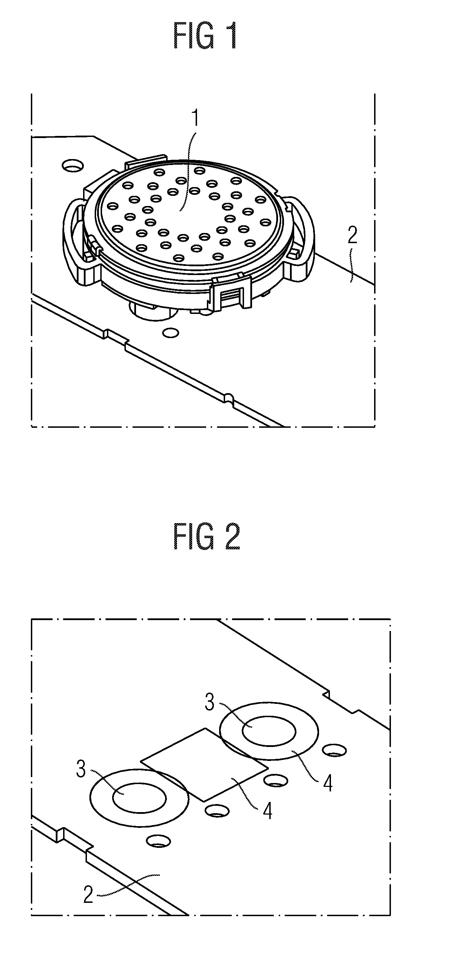

Eine erste Art der Kontaktierung ist eine Druckkontaktierung mit Hilfe von Spiralfedern als elektrisch leitende Verbin dungsteile. Eine solche Druckkontaktierung ist in den Figuren 1 bis 3 näher gezeigt.

Nachteilig bei einer solchen Kontaktierungsart ist der hohe Platzbedarf, der für die Spiralfedern benötigt wird.

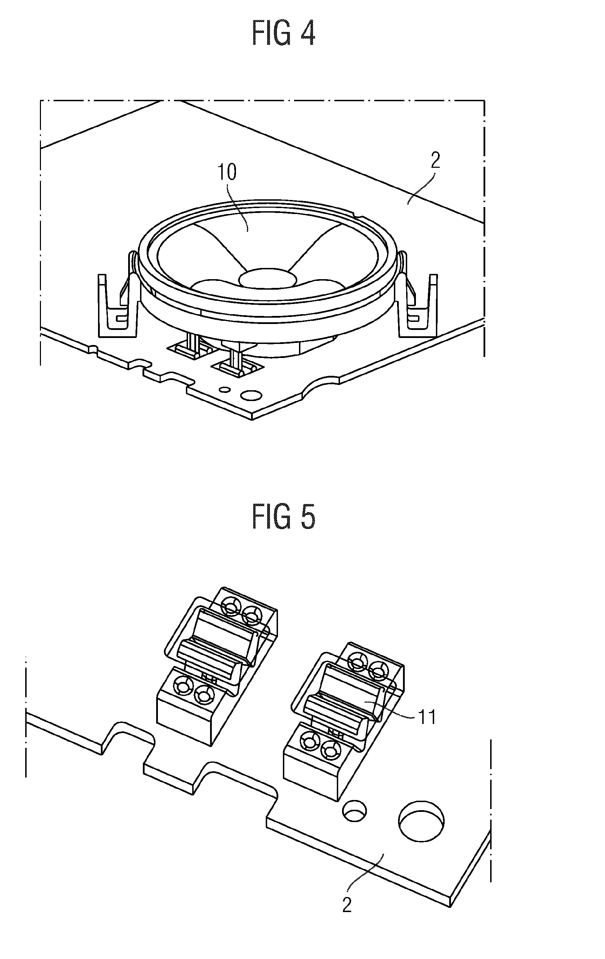

Eine andere Art der Kontaktierung verwendet Klemmkontakte. In den Figuren 4 bis 6 ist eine Klemmkontaktierung näher dargestellt.

Eine Klemmkontaktierung benötigt in nachteiliger Weise einen hohen Kraftaufwand bei der Montage. Weiter nachteilig ist, dass die bei der Montage aufzuwendende Kraft sowohl durch die Leiterplatte als auch durch den Lautsprecher aufgefangen werden muss. Außerdem ist bei einer automatisierten Montage die Klemmkontaktierung nur schwer handhabbar.

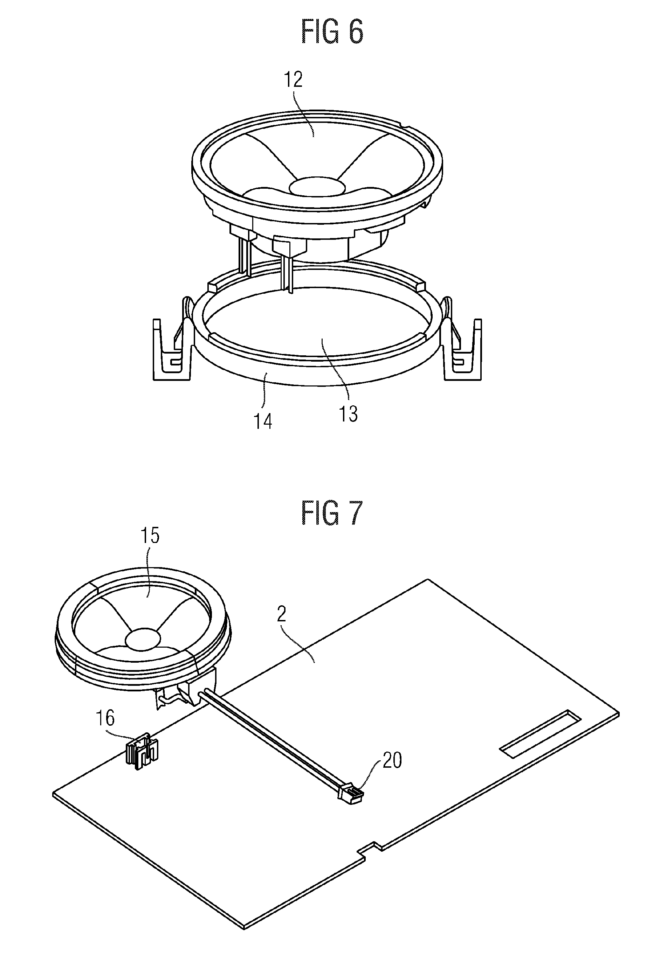

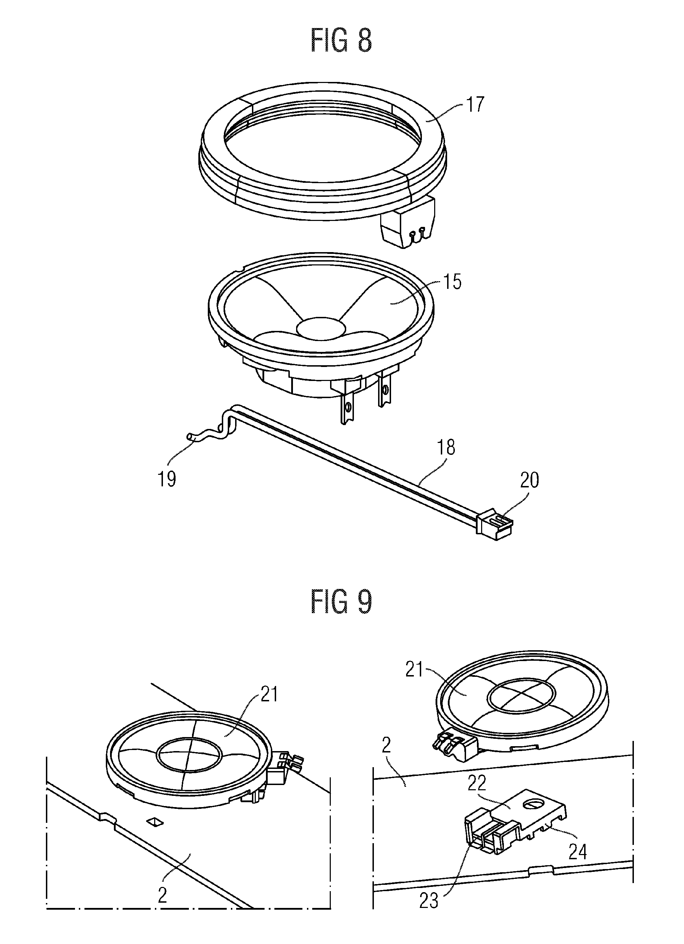

Bei einer weiteren Realisierungsart der Kontaktierung ist eine Stecker-Buchsen-Kombination eingesetzt. Die Kontaktierungsart mittels eines Steckers und einer Buchse ist in den Figuren 7 und 8 näher dargestellt.

Die Kombination aus einem Stecker und einer Buchse stellt wegen der Bauteilekosten und der Handhabung eine teure Art der Kontaktierung dar. Außerdem wird noch ein Kabel benötigt, das zusätzliche Bauteilekosten verursacht. Insgesamt ist mit diesen Bauteilen eine automatische Montage nur schwer zu bewerkstelligen.

Aufgabe der vorliegenden Erfindung ist es, Mittel zum Kontaktieren von in Kommunikationsendgeräten platzierten elektrotechnischen Komponenten anzugeben, die eine leicht handzuhabende und auch automatisierte Montage ermöglichen und die kostengünstig sind. Ferner ist es Aufgabe der Erfindung, ein Kommunikationsendgerät der eingangs genannten Art anzugeben, das kostengünstiger hergestellt werden kann.

Der erste Teil der Aufgabe wird ausgehend von Mitteln der eingangs genannten Art erfindungsgemäß durch solche Mittel gelöst, die die Merkmale des kennzeichnenden Teils des Anspruchs 1 aufweisen.

Derartige Mittel ermöglichen eine vereinfachte und automatisierte Montage und sie sind kostengünstig, weil nur ein nicht teures mechanisches Körperteil zusätzlich benötigt wird, dafür aber teure Speziallösungen eingespart werden können. Eine einfache und automatische Montage ist möglich, weil die Mittel behandelt werden können wie elektrische Bauelemente, das heißt sie können genau wie diese bestücktechnisch gehandhabt werden.

Die erfindungsgemäßen Mittel ermöglichen, dass elektrotechnische Komponenten handelsüblicher Art eingesetzt werden können. Mussten in verschiedenen Fällen Maßunterschiede an Einbauorten durch teure Spezialanfertigungen von elektronischen Bauelementen ausgeglichen werden, so können jetzt handelsübliche Bauelemente eingesetzt werden, wobei die verbleibenden Maßunterschiede durch das nicht teure mechanische Körperteil ausgeglichen werden. Ein weiterer Vorteil ist, dass Designänderungen jetzt auch wesentlich leichter durchführbar sind bzw. solchen Designänderungen wesentlich leichter nachgekommen werden kann.

Der zweite Teil der Aufgabe wird bei Kommunikationsendgeräten der eingangs genannten Art erfindungsgemäß dadurch gelöst, dass deren Montagekosten durch Einsatz der oben beschriebenen Mittel wesentlich verbilligt werden.

Vorteilhafte Ausgestaltungen der Erfindung sind Gegenstand von Unteransprüchen.

Danach weisen die besagten Kontaktierungsmittel unterseitig einen frei zugänglichen offenen Hohlraum auf, durch den es möglich ist, dass auf einer von den Kontaktierungsmittel überdeckten Fläche auf einer Leiterplatte einer zugeordneten elektrotechnischen Funktionsbaugruppe noch weitere elektrische Bauelemente nützlich vorsehbar sind. Das Vorsehen von Lötstücken und Abstützelementen an verschiedenen günstigen Stellen der Mittel ermöglichen insbesondere eine Montage der Mittel wie elektrische Bauelemente. Speziell angeformte Andruckflächen in Richtung zu einer zu montierenden elektrotechnischen Komponente ermöglichen eine einfache Druckkontaktierung der elektrotechnischen Komponente. Die dabei auftretenden Kräfte können leicht durch das mechanische Körperteil der erfindungsgemäßen Mittel abgefangen werden.

Bei einem Kommunikationsendgerät können die vorbeschriebenen erfindungsgemäßen Mittel zumindest für die Montage der Lautsprecher eingesetzt werden, wodurch sich dann schon die Gesamtkosten für das Kommunikationsendgerät verringern.

Nachfolgend wird die Erfindung anhand einer Zeichnung näher erläutert. Darin zeigen:
- Figur 1: ein Lautsprechermodul gemäß dem Stand der Technik,
- Figur 2: einen zum Lautsprechermodul gemäß der Figur 1 gehörenden Kontaktierungsflächenabschnitt auf einer zugeordneten Leiterplatte,
- Figur 3: eine Explosionsdarstellung bezüglich des Lautsprechermoduls gemäß der Figur 1,
- Figur 4: ein weiteres Lautsprechermodul gemäß dem Stand der Technik,
- Figur 5: eine Klemmkontaktvorrichtung für ein Lautsprechermodul gemäß der Figur 4,
- Figur 6: eine Explosionsdarstellung bezüglich des Lautsprechermoduls gemäß der Figur 4,
- Figur 7: ein drittes Lautsprechermodul gemäß dem Stand der Technik,
- Figur 8: eine Explosionsdarstellung bezüglich des Lautsprechermoduls gemäß der Figur 7,
- Figur 9: ein weiteres Lautsprechermodul gemäß dem Stand der Technik in Kombination mit erfindungsgemäßen Mitteln zum Kontaktieren dieses Lautsprechermoduls mit einer elektrotechnischen Funktionsbaugruppe gemäß dem Stand der Technik,
- Figur 10: eine Montagesituation des Lautsprechermoduls gemäß der Figur 9,
- Figur 11: eine Montagesituation gemäß der erfindungsgemäßen Kontaktierungsmittel,
- Figur 12: eine Einzelbilddarstellung der erfindungsgemäßen Kontaktierungsmittel,
- Figur 13: eine Unteransicht der Kontaktierungsmittel gemäß der Figur 13, und
- Figur 14: eine Schnittdarstellung einer montierten Kombination aus einem Lautsprechermodul, einer Leiterplatte und den erfindungsgemäßen Kontaktierungsmitteln.

In der Figur 1 ist ein Lautsprechermodul 1 gezeigt, das auf einer Leiterplatte 2 mittels einer Druckkontaktierung montiert ist.

In der Figur 2 ist ein Kontaktierungsflächenabschnitt für das Lautsprechermodul 1 auf der zugeordneten Leiterplatte 2 gezeigt. Im Einzelnen sind innere Kreise 3 als eigentliche Kontaktierungsflächen gezeigt. Ferner sind aus äußeren Kreisen und einem Rechteck gebildete Freiräume 4 gezeigt. Der rechteckige Freiraum 4 stellt beispielsweise den Platz für ein Schaumstoffteil für eine Druckkompensation dar.

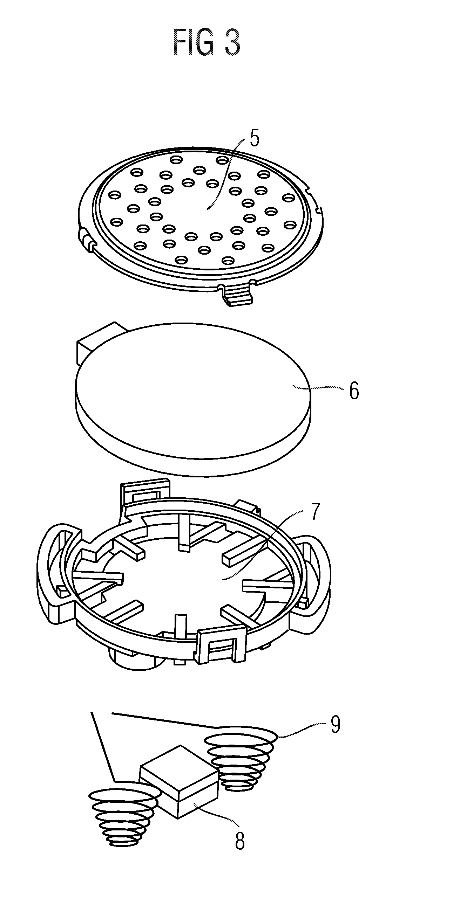

In der Figur 3 sind einzelne Bestandteile des Lautsprechermoduls 1 zu sehen. Insbesondere sind ein Abschirmblech 5, der eigentliche Lautsprecher 6 in einer schematischen Darstellung, ein Halter 7, ein Schaumstoffteil 8 und Spiralfedern 9 als elektrische Verbindungselemente dargestellt.

In der Figur 4 ist ein anderes Lautsprechermodul 10 abgebildet, das auf Federn geklemmt auf die Leiterplatte 2 montiert ist.

In der Figur 5 sind die Leiterplatte 2 der Figur 4 zu sehen, auf der Klemmkontakte 11 für die Klemmkontaktierung montiert sind.

In der Figur 6 ist das Lautsprechermodul 10 in einer Explosionsdarstellung gezeigt. Im Einzelnen sind ein eigentliches Lautsprecherteil 12 mit Klemmkontakten 13 und ein Andruckring 14 an Stelle beispielsweise eines Schaumstoffteils 8 gezeigt.

In der Figur 7 ist ein weiteres Lautsprechermodul 15 und eine Leiterplatte 2 mit einer Buchse 16 gezeigt.

In der Figur 8 ist ein Gummidichtring 17 für das Lautsprechermodul 15 und das Lautsprechermodul 15 mit Lötkontakten gezeigt. Ferner ist ein Kabel 18 für den elektrischen Anschluss des Lautsprechermoduls 15 angegeben. Das Kabel 18 hat an seinem einen Ende Lötstellen 19 für ein Anlöten an die Lötkontakte des Lautsprechermoduls 15 angebracht. An dem anderen Ende des Kabels 18 ist ein Stecker 20 montiert, der in die Buchse 16 für die elektrische Kontaktierung einsteckbar ist.

In der Figur 9 ist ein weiteres Lautsprechermodul 21 für eine Druckkontaktierung auf der Leiterplatte 2 gezeigt. Insbesondere ist in einer linken Hälfte das Lautsprechermodul 21 im montierten Zustand auf der Leiterplatte 2 gezeigt, während es in einer rechten Hälfte der Figur 9 in einer Situation vor der Montage gezeigt ist. Als Kontaktierungsmittel für die elektrische Kontaktierung des Lautsprechermoduls 21 ist ein Kontaktierungsmodul 22 verwendet, das elektrisch leitende Verbindungsteile 23 mit einem mechanischen Körperteil 24 kombiniert hat.

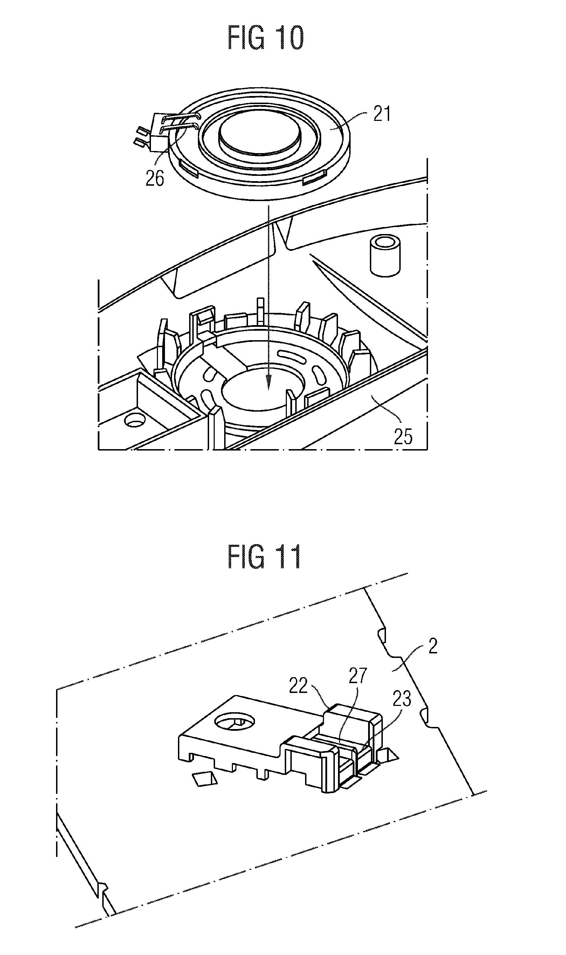

In der Figur 10 ist gezeigt, wie das Lautsprechermodul 21 der Figur 9 mit Schaumstoff (in der Figur 10 nicht näher dargestellt) in eine Oberschale 25 eines Kommunikationsendgeräts eingerastet wird.

In der Figur 11 ist eine Leiterplatte 2 mit den Kontaktierungsmittel 22 der Figur 10 gezeigt, wobei die Kontaktierungsmittel 22 auf die Leiterplatte 2 montiert sind. Bei einem weiteren Montagevorgang bei der Montage nach der Figur 10 wird die Einheit bestehend aus Leiterplatte 2 und Kontaktierungsmittel 22 gemäß der Figur 11 gestürzt ebenfalls in die Oberschale 25 (Figur 10) montiert. Dabei kommen Andruckfedern 26 des Lautsprechermoduls 21 in elektrisch leitenden Kontakt mit den Verbindungsteilen 23 der Kontaktierungsmittel 22. Der Kontakt wird insbesondere auf Andruckflächen 27 der Verbindungsteile 23 hergestellt.

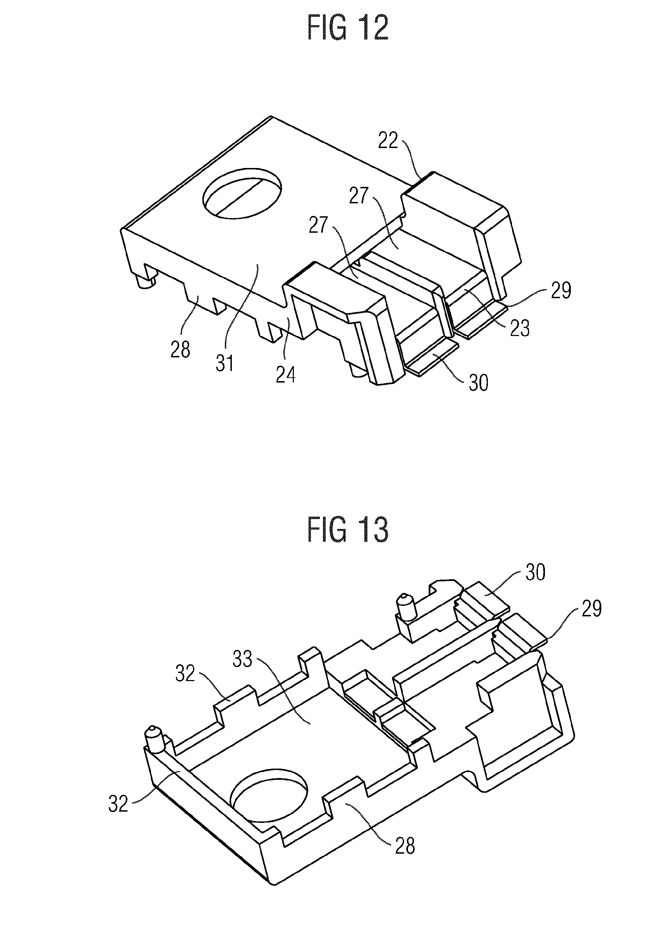

In der Figur 12 ist in einer Einzelbilddarstellung das Kontaktierungsmodul 22 dargestellt. Das mechanische Körperteil 24 des Kontaktierungsmoduls 22 ist beispielsweise unter Verwendung eines hitzebeständigen Kunststoffs als Trägerteil hergestellt. Die elektrisch leitenden Verbindungsteile 23 sind beispielsweise als Kontaktierungsbleche ausgebildet, die die Andruckfläche 27 für eine Druckkontaktierung durch beispielsweise ein Lautsprechermodul 21 (Figur 10) haben. Die Kombination aus einem mechanischen Körperteil 24 und elektrisch leitenden Verbindungsteilen 23 umfasst weiter elektrotechnische und mechanische Teilstücke 28, 29, durch die eine Montage des Kontaktierungsmoduls 22 in elektrischer und mechanischer Hinsicht wie die Montage eines elektronischen Bauteils möglich ist. Im Einzelnen handelt es sich bei dem bzw. den Teilstücken 28 um Stützelemente, durch die sich das Kontaktierungsmodul 22 beispielsweise auf einer Leiterplatte 2 abstützen kann. Bei dem bzw. den Teilstücken 29 handelt es sich beispielsweise um Lötstücke 30, die es ermöglichen, dass das Kontaktierungsmodul 22 beispielsweise auf eine Leiterplatte 2 aufgelötet werden kann.

Zum Aufsitzen eines Lautsprechermoduls 21 (Figur 10) auf das Kontaktierungsmodul 22 weist das Kontaktierungsmodul 22 ein Auflager 31 für das Lautsprechermodul 21 (Figur 10) auf. Unterhalb des Kontaktierungsmoduls 22 weist das Kontaktierungsmodul 22 Wandungen 32 auf, die auf der Unterseite des Kontaktierungsmoduls 22 einen nach unten offenen Hohlraum umfassen.

In der Figur 13 ist das Kontaktierungsmodul 22 nochmals von unten zu sehen.

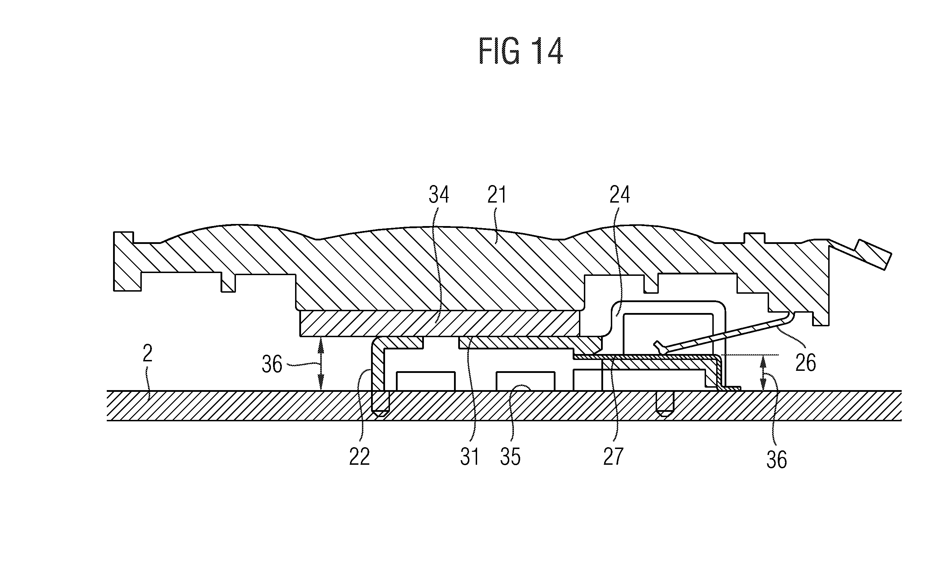

In der Figur 14 ist als ein Lautsprecher der Lautsprecher 21 (Figur 10) zu sehen, der mit einem Schaumstoffpad 34 auf dem Auflager 31 des Kontaktierungsmoduls 22 sitzt. Das Kontaktierungsmodul 22 ist seinerseits auf die Leiterplatte 2 montiert. Der Lautsprecher 21 weist Kontaktfedern 26 auf, die auf die Andruckflächen 27 der Verbindungsteile 23 drücken. Auf dem Flächenstück 35 der Leiterplatte 2 unterhalb des Kontaktierungsmoduls 22 in dessen Hohlraum 33 sind elektronische Bauteile (in der Figur nicht näher dargestellt) platziert.

Je nach dem in welcher Höhe der Lautsprecher 21 (Figur 10) im montierten Zustand zur Leiterplatte 2 zu liegen kommt, wird nach entsprechender maßlicher Fertigung des mechanischen Körperteils 24 und des elektrischen Verbindungsteils 23 des Kontaktierungsmoduls 22 der Freiraum 36 zwischen dem Lautsprecher 21 und der Leiterplatte 2 mechanisch und elektrisch ausgefüllt bzw. überbrückt. Die angesprochene Höhe wird beispielsweise durch die Bauform des Lautsprechers 21 und/oder dessen gewählten Einbauort eingestellt.

Das Kontaktierungsmodul 22 kann in Kommunikationsendgeräten eingesetzt werden, die aus einem frei beweglichen schnurlosen oder schnurgebundenen Teil und einem zugehörigen Basisteil bestehen, in denen elektrotechnische Funktionsbaugruppen wie zum Beispiel eine Leiterplatte mit Funktionsschaltungen und elektrotechnische Komponenten wie zum Beispiel Lautsprecher enthalten sind.

## Patentansprüche

1. Mittel zum Kontaktieren von in Kommunikationsendgeräten platzierten elektrotechnischen Komponenten(z.B. 21), umfassend elektrisch leitende Verbindungsteile (23) zum elektrisch leitenden Verbinden der elektrotechnischen Komponente (z.B. 21) mit einer elektrotechnischen Funktionsbaugruppe (2) des Kommunikationsendgeräts, **dadurch gekennzeichnet, dass** die elektrisch leitenden Verbindungsteile (23) mit einem mechanischen Körperteil (24) kombiniert sind in einer insgesamt solchen gestaltungstechnischen Weise, dass ein auf Grund einer vorgegebenen Bauform der elektrotechnischen Komponente (z.B. 21) und eines vorgegebenen Einbauortes der elektrotechnischen Komponente (z.B. 21) innerhalb des Kommunikationsendgeräts zwischen der elektrotechnischen Funktionsbaugruppe (2) des Kommunikationsendgeräts und der elektrotechnischen Komponente (z.B. 21) vorhandener Freiraum (36) elektrisch in Form einer elektrischen Verbindung zwischen der elektrotechnischen Komponente (z.B. 21) und der elektrotechnischen Funktionsbaugruppe (2) und mechanisch in Form eines zur elektrotechnischen Funktionsbaugruppe (2) gehörenden Auflagers (31) für die elektrotechnische Komponente (z.B. 21) überbrückt ist, und dass in Richtung zur elektrotechnischen Funktionsbaugruppe (2) hin elektrotechnische und mechanische Teilstücke (28; 29) an dieser Kombination vorhanden sind, durch die eine Montage in elektrischer und mechanischer Hinsicht wie bei einem elektronischen Bauteil durchführbar ist.

2. Mittel nach Anspruch 1, **dadurch gekennzeichnet, dass** das mechanische Körperteil (24) in Richtung zur elektrotechnischen Funktionsbaugruppe (2) Wandungen (32) aufweist, die zwischen sich einen zur elektrotechnischen Funktionsbaugruppe (2) hin offenen Hohlraum (33) umfassen.

3. Mittel nach Anspruch 1 oder 2, **dadurch gekennzeichnet, dass** die Teilstücke (28; 29) für eine elektrische Montage als Lötstücke (30) und für eine mechanische Montage wenigstens zum Teil als Abstützelemente gegenüber der elektrotechnischen Funktionsbaugruppe (2) ausgebildet sind.

4. Mittel nach einem der Ansprüche 1 bis 3, **dadurch gekennzeichnet, dass** in Richtung der elektrotechnischen Komponente (z.B. 21) elektrisch kontaktierbare Andruckflächen (27) für eine weiterführende Kontaktierung zur elektrotechnischen Komponente (z.B. 21) bereitgestellt sind.

5. Kommunikationsendgerät bestehend aus einem frei beweglichen schnurlosen oder schnurgebundenen Teil und einem zugehörigen Basisteil, die jeweils für sich eine elektrotechnische Funktionsbaugruppe (2) und eine elektrotechnische Komponente (z.B. 21) aufweisen, **dadurch gekennzeichnet, dass** Mittel (22) gemäß einem der Ansprüche 1 bis 4 zum Kontaktieren der elektrotechnischen Komponente (z.B. 21) mit der elektrotechnischen Funktionsbaugruppe (2) vorgesehen sind.

6. Kommunikationsendgerät nach Anspruch 4, **dadurch gekennzeichnet, dass** die Mittel (22) in dem frei beweglichen schnurlosen bzw. schnurgebundenen Teil und/oder in dem jeweiligen zugehörigen Basisteil angeordnet sind.

7. Kommunikationsendgerät nach Anspruch 4 oder 5, **dadurch gekennzeichnet, dass** die elektrotechnische Komponente (z.B. 21) ein Lautsprecher und die elektrotechnische Funktionsbaugruppe (2) eine Flachbaugruppe mit einer Leiterplatte ist.
